# EUROPÄISCHE PATENTSCHRIFT

(11) **EP 2 667 692 B1**
(45) Veröffentlichungstag und Bekanntmachung des Hinweises auf die Patenterteilung: **12.10.2016**
(21) Anmeldenummer: 12168664.6
(22) Anmeldetag: 21.05.2012
(51) Int. Cl.: H05K 7/14, H05K 7/20

(54) **Vorrichtung zur Verklemmung eines Leiterplattenmoduls in einer Befestigungsnut**
Device for clamping a circuit board module in a fixing nut
Dispositif de blocage d'un module de cartes de circuits imprimés dans une encoche de fixation

(43) Veröffentlichungstag der Anmeldung: 27.11.2013
(73) Patentinhaber: Pentair Technical Solutions GmbH, 75334 Straubenhardt (DE)
(72) Erfinder: Rutherford, Paul, 76228 Karlsruhe (DE); Pawlowski, Dr. Adam, 76337 Waldbronn (DE)
(74) Vertreter: Durm & Partner

(56) Entgegenhaltungen:
- EP-A1- 0 071 398
- GB-A- 2 101 812
- US-A- 5 472 353
- US-A- 5 485 353
- US-A- 5 859 764

## Beschreibung

Die Erfindung betrifft eine Vorrichtung zur Verklemmung eines Leiterplattenmoduls in einer Befestigungsnut einer Kühlplatte.

In der Industrieelektronik hat sich eine modulare Bauweise durchgesetzt. Elektronische Bauelemente wie Prozessoren, Halbleiterchips, Widerstände und Kondensatoren werden auf gedruckte Leiterplatten mit genormter Größe gesetzt. Mehrere Leiterplatten werden dann in ein Gehäuse oder einen Baugruppenträger eingeschoben und dort verriegelt. Die einzelnen Leiterplatten tragen an der hinteren Kante vielpolige Steckverbinder, die in eingeschobenem Zustand mit korrespondierenden Steckverbindern einer Backplane im Gehäuse bzw. Baugruppenträger mechanisch und elektrisch verbunden sind.

Für Anwendungen in rauen Umgebungen wie zum Beispiel auf Schiffen, in Flugzeugen, bei mobiler Kommunikation oder in der Öl- und Gasindustrie werden an die mechanische Stabilität und die Staubdichtigkeit elektronischer Geräte spezielle, sehr hohe Anforderungen gestellt. Bei immer höherer Leistungsfähigkeit und Packungsdichte der Elektronik stellt auch die Kühlung der elektronischen Bauelemente, insbesondere der Prozessoren, eine besondere Herausforderung dar.

Für solche spezielle Anforderungen wurden besonders stabile Aufbausysteme entwickelt, bei denen die elektronischen Leiterplatten zwischen Metallplatten gepackt werden und die so entstandenen Leiterplattenmodule nicht in gewöhnliche Führungsschienen eingesetzt, sondern auf speziellen Befestigungsplatten aus massivem Metall befestigt werden. Hierzu sind in den Befestigungsplatten Nuten mit rechteckigem Querschnitt eingearbeitet, welche den unteren Rand eines Leiterplattenmoduls aufnehmen.

Das Einpacken der Leiterplatten in Metallplatten stellt nicht nur einen mechanischen Schutz für die empfindliche Elektronik dar, sondern dient gleichzeitig auch der Abführung der Verlustleistung nach außen. Die Wärmeableitung solcher konduktionsgekühlten Module erfolgt über die metallene Befestigungsplatte, welche deshalb auch als Kühlplatte bezeichnet werden kann.

Um die geforderte hohe mechanische Stabilität und eine optimale Wärmeableitung zu erzielen, genügt es nicht, die Leiterplattenmodule einfach in die Befestigungsnuten der Kühlplatte einzuschieben und dort gegen unbeabsichtigtes Herausziehen zu verriegeln. Vielmehr erfolgt die Befestigung mittels spezieller Klemmvorrichtungen, die parallel zum Leiterplattenmodul in die Befestigungsnut eingeschoben werden und anschießend den unteren Rand des Moduls zwischen den Wänden der Befestigungsnut verklemmen.

Klemmbefestiger zur Herstellung einer form- und kraftschlüssigen Verbindung zwischen Leiterplattenmodul und Kühlplatte und zur gleichzeitigen Herstellung eines gut wärmeleitenden Kontakts zwecks Wärmeableitung sind aus dem Stand der Technik bekannt und werden zum Beispiel von der CALMARK Corporation, CA 91776, USA unter der Bezeichnung Card-Lok angeboten. Ähnliche Klemmbefestiger werden von der Pentair Inc., Minneapolis, USA unter dem Markennamen BIRTCHER Wedge-Lok vertrieben.

Die vorbekannten Befestigungsvorrichtungen umfassen eine Anzahl von Keilstücken, die auf einer Gewindewelle aufgereiht und von dieser zusammengehalten werden. Durch Drehen der Gewindewelle werden die Keilstücke zusammengezogen, wobei mindestens ein Keilstück unter dem Druck auf seine Keilflächen seitlich ausweicht. Auf diese Weise verbreitert sich die Befestigungsvorrichtung, so dass es sich in der Befestigungsnut der Kühlplatte festklemmt. Solche und ähnliche Befestigungsvorrichtungen mit keilförmigen Klemmelementen sind zum Beispiel in US 4,819,713 (entsprechend DE 3 890 343 C2), EP 0 772 380 B1 oder GB 2191046 A (entsprechend DE 3 717 689 A1) beschrieben.

Obwohl sich die erwähnten Befestigungsvorrichtungen mit Keilelementen seit vielen Jahren gut bewährt haben, sind damit auch Nachteile verbunden, insbesondere was die Fähigkeit betrifft, Wärme von den konduktionsgekühlten Leiterplattenmodulen abzuführen. Die aufeinander gleitenden Schrägen der Keilstücke bieten nur eine relativ geringe Fläche, durch welche die Wärme fließen kann. Dies hängt damit zusammen, dass die Keilstücke nicht massiv, sondern als U-Profile ausgebildet werden müssen, damit die Gewindespindel durch sie hindurch geführt werden kann. Nur diejenigen Keilstücke, die unter dem Druck der Gewindespindel seitlich ausweichen, liegen flächig an der Nutwand an. Somit steht auch nur deren Länge als Kontaktfläche für die Wärmeübertragung zur Kühlplatte zur Verfügung. Die in Gegenrichtung verschobenen Keilelemente können die aufgenommene Wärme nur über die relativ kleinen Schrägflächen an die benachbarten Keilelemente abgeben.

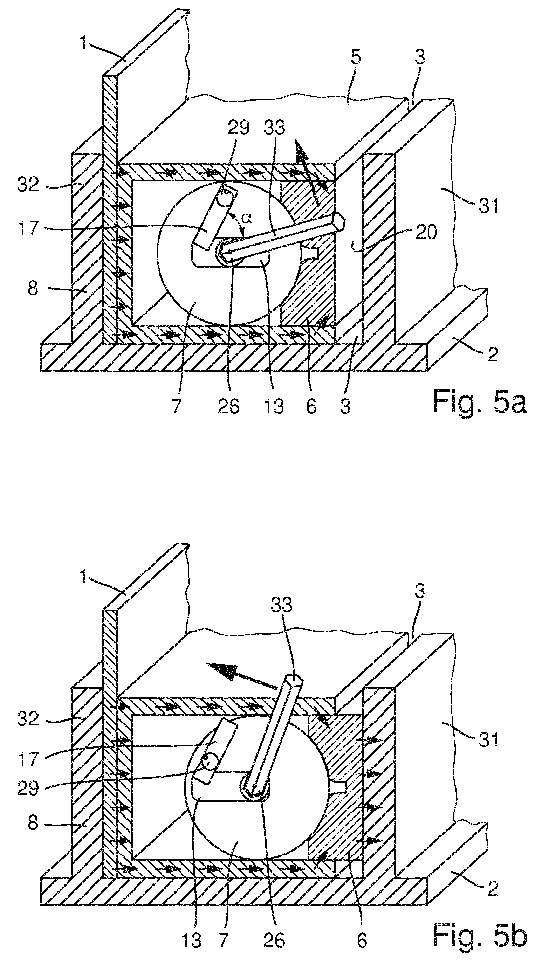

US 5,859,764 beschreibt unter anderem eine Klemmvorrichtung, die im Wesentlichen aus zwei keilförmigen Druckstücken besteht (Figur 5). Das erste Keilstück hat abschnittsweise einen U-förmigen Querschnitt und bildet eine Führung für das zweite Keilstück. Das zweite Keilstück hat die Form eines spitzen Keils mit rechteckigem Querschnitt, der zur Keilspitze hin abnimmt. Eine lange Gewindeschraube durchsetzt die beiden Keilstücke und verbindet diese miteinander. Beim Verdrehen der Schraube verschieben sich die beiden Keilstücke in Längsrichtung gegeneinander mit der Folge, dass die Gesamtdicke der Klemmvorrichtung wächst. Mit zunehmender Verschiebung verringert sich dabei die Kontaktfläche zwischen den beiden Keilstücken, so dass die Wärmeübertragung vom einen auf das andere Keilstück nicht mehr über die gesamte Länge der Klemmvorrichtung möglich ist. Die die beiden Keilstücke durchsetzende Bohrung für die Schraube stellt ein Hindernis für den Wärmefluss dar.

Ein weiterer Nachteil dieser vorbekannten Konstruktion besteht darin, dass die für die Klemmwirkung erforderliche Vergrößerung der Dicke zwangsweise mit einer Vergrößerung der Länge der Vorrichtung einhergeht, was zu Platzproblemen beim Einbau in der Befestigungsnut der Kühlplatte führen kann. Das Dokument US 5,485,353 beschreibt eine Klemmvorrichtung über die Wärme aus einer Leiterplatte abgeleitet wird.

Aufgabe der Erfindung ist die Schaffung einer konstruktiv einfachen, stabilen und gut zu bedienenden Vorrichtung zur Verklemmung eines Leiterplattenmoduls in einer Befestigungsnut einer Kühlplatte, welche ausreichend hohe Klemmkräfte erzeugt, vor allem aber eine bessere Wärmeableitung vom Leiterplattenmodul in die Kühlplatte bietet.

Die Aufgabe wird gelöst durch eine Vorrichtung mit den Merkmalen des ersten Patentanspruchs.

Erfindungsgemäß fährt ein massives Druckstück aus dem U-förmigen Gehäuse aus und legt sich mit seiner an der Vorderseite ausgebildeten ebenen Druckfläche an die gegenüberliegende Wand der Befestigungsnut an. Der Druck wird dabei durch einen Antriebsmechanismus erzeugt, der in den Raum zwischen der Rückwand des Gehäuses und dem Druckstück eingeschoben ist und das Druckstück durch die offene Vorderseite des Gehäuses zumindest so weit vorschiebt, dass es die parallelen Seitenwände des Gehäuses überragt.

In dieser vorgeschobenen Position liegt das Druckstück an einer Wand der Befestigungsnut an, so dass eine Klemmkraft quer zur Nut aufgebaut werden kann. Die Rückwand des Gehäuses wird dabei gegen das Leiterplattenmodul presst.

Die Verbreiterung oder Aufspreizung der Klemmvorrichtung erfolgt erfindungsgemäß durch Herausdrücken des Druckstücks aus dem offenen Gehäuse. Gegenüber den bekannten Klemmbefestigern mit Keilstücken, die gegeneinander aus der Längsachse verschoben und gegen eine Wand der Befestigungsnut gedrückt werden, kann das erfindungsgemäße Druckstück über die gesamte Länge des Gehäuses ausgeführt sein. Bei Bedarf kann das Druckstück auch unterteilt werden. In jedem Fall steht aber die gesamte Länge des Druckstücks zur Übertragung von Klemmkräften und, vor allem, zur Wärmeübertragung zur Verfügung. Dies wird dadurch unterstützt, dass das Druckstück zwischen den Seitenwänden des Gehäuses gleitend gelagert ist, so dass zwischen Gehäuse und Druckstück ein großflächiger Kontakt besteht, über den Wärme aus dem Leiterplattenmodul durch Konduktion abgeführt werden kann. Die Übergänge zwischen den aufeinander gleitenden Schrägen der Keilstücke bei den herkömmlichen Konstruktionen, die sich aufgrund der relativ kleinen Flächen als Flaschenhals für die Wärmeübertragung erwiesen haben, werden bei der erfindungsgemäßen Konstruktion umgangen und ersetzt durch vergleichsweise große Kontaktflächen zwischen Gehäuse und Druckstück.

Das Druckstück kann sich über die gesamte Länge des Gehäuses erstrecken, insbesondere wenn es aus massivem Stahl gefertigt ist. Es ist allerdings auch möglich, das Druckstück mehrteilig auszubilden, was insbesondere dann in Betracht kommt, wenn das Gehäuse sehr lang ausgeführt ist und zur Halterung von Leiterplattenmodulen mit entsprechend langer Kantenlänge eingesetzt werden soll. Stets bewegen sich aber die Teil-Druckstücke parallel und in gleicher Richtung, dass heißt, die Teil-Klemmflächen liegen immer in einer Ebene.

Das Druckstück hat einen im Prinzip rechteckigen Querschnitt, der dem Querschnitt des U-förmigen Gehäuses angepasst ist. Das Druckstück ist damit direkt zwischen den Seitenwänden des Gehäuses gleitend gelagert. Dies ergibt einen großflächigen Kontakt, über den die Wärme vom Gehäuse direkt auf das Druckstück und von diesem auf die Kühlplatte übertragen wird.

Eine weitere optionale Maßnahme zur Verbesserung der Wärmeableitung besteht darin, dass das Druckstück an seiner Rückseite einen mittig angeordneten Längsschlitz aufweist, der sich über seine gesamte Länge erstreckt. Dieser Längsschlitz wirkt wie eine Kerbe und führt dazu, dass sich das Druckstück unter dem mechanischen Druck, der vom Antriebsmechanismus auf das Druckstück ausgeübt wird, geringfügig aufbiegt, so dass es sich von innen an die Seitenwände des Gehäuses anlegt und dadurch eine sehr gute Wärmeübertragung erzielt wird.

Um das Druckstück parallel zur Rückwand des Gehäuses zu verschieben, könnten im Prinzip verschiedene Antriebsmechanismen eingesetzt werden. Wichtig ist nur, dass der Antriebsmechanismus im Innern des U-förmigen Gehäuses, nämlich in dem Raum zwischen Gehäuserückwand und Druckstück, angeordnet ist, eine Klemmkraft zwischen dem verschieblich gelagerten Druckstück und der ortsfesten Rückwand des Gehäuses aufbauen kann und es möglich ist, den Mechanismus von außen mit der Hand zu betätigen.

Erfindungsgemäß umfasst der Antriebsmechanismus für das Druckstück eine Anzahl von Keilelementen, die auf eine Gewindewelle aufgereiht sind, deren Achse parallel zur Rückwand des Gehäuses verläuft. Durch Drehen der Gewindewelle weicht mindestens ein Keilstück unter dem Druck auf seine Keilflächen seitlich aus, wodurch es sich von innen an das Druckstück anlegt und dieses nach vorne aus dem Gehäuse herausdrückt. Die sich gegenläufig verschiebenden Keile drücken sich von innen an die Rückseite des Gehäuses an und erzeugen den Gegendruck.

Geeignete Klemmmechanismen mit Keilen sind auf dem Markt erhältlich, und zwar in Form der bekannten Klemmbefestiger, die zum Beispiel von der CALMARK Corporation unter der Bezeichnung Card-Lok angeboten werden. Im Rahmen der Erfindung wird ein solches Card-Lok einfach längs in das U-förmige Gehäuse eingeschoben, und zwar in den Zwischenraum zwischen Rückseite und Druckstück. Das Card-Lok verklemmt sich hier allerdings nicht direkt zwischen dem Leiterplattenmodul und einer Wand der Befestigungsnut, sondern zwischen der Innenseite der Gehäuserückwand und der Rückseite des Druckstücks. Die Antriebs- bzw. Klemmfunktion ist also getrennt von der Funktion der Wärmeableitung, die erfindungsgemäß über das Gehäuse und das Druckstück erfolgt und damit unabhängig vom eingesetzten Antriebsmechanismus ist.

Ein Ausführungsbeispiel der Erfindung wird nachstehend anhand der beigefügten Zeichnungen näher beschrieben. Es zeigen:
- Figur 1: ein Leiterplattenmodul, eine Klemmvorrichtung (die nicht in allen Einzelheiten der Erfindung entspricht) und eine Kühlplatte, in stark vereinfachter perspektivischer Darstellung;
- Figur 2: die Einzelteile der Klemmvorrichtung von Fig. 1, in teilweise geschnittener perspektivischer Darstellung;
- Figur 3: die Klemmvorrichtung gemäß Fig. 2, teilweise zusammengebaut;
- Figur 4: die Klemmvorrichtung gemäß Fig. 2 in zusammengebautem Zustand;
- Figur 5a, 5b: die Funktion der Klemmvorrichtung gemäß Fig. 2 im Zusammenwirken mit einem Leiterplattenmodul und einer Kühlplatte.
- Figur 6: eine erfindungsgemäße Klemmvorrichtung, in teilweise geschnittener perspektivischer Darstellung

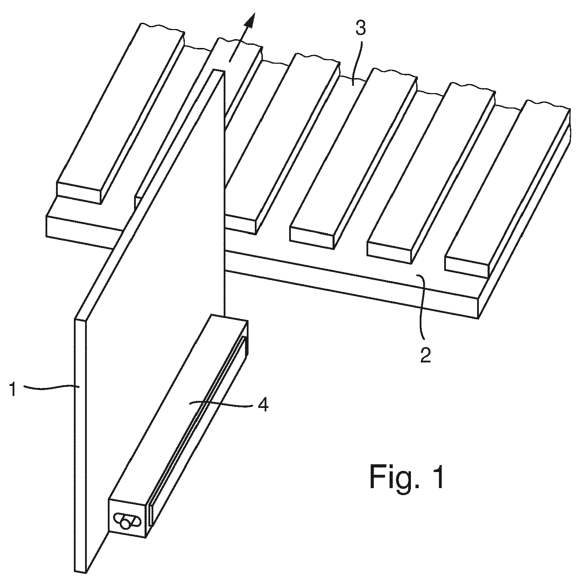

In Figur 1 ist ein Leiterplattenmodul 1 zu sehen, das in aufrechter Lage auf der Oberseite einer Kühlplatte 2 befestigt werden soll. Hierzu sind an der Oberseite der Kühlplatte 2 eine Reihe von parallelen Befestigungsnuten 3 ausgebildet, in die jeweils ein Leiterplattenmodul 1 eingeschoben werden kann. Zumindest die Außenseite des Leiterplattenmoduls 1 als auch die Kühlplatte 2 sind aus gut wärmeleitfähigem Metall, um die Verlustwärme der elektronischen Bauelemente durch Wärmeleitung abzuführen.

Zur Halterung des Leiterplattenmoduls 1 in der Befestigungsnut 3 der Kühlplatte 2 dient eine Klemmvorrichtung, die den unteren Rand des Leiterplattenmoduls 1 zwischen den Nutenwänden der Befestigungsnut 3 verklemmt und gleichzeitig einen großflächigen Wärmekontakt zwischen Leiterplattenmodul 1 und Kühlplatte 2 herstellt.

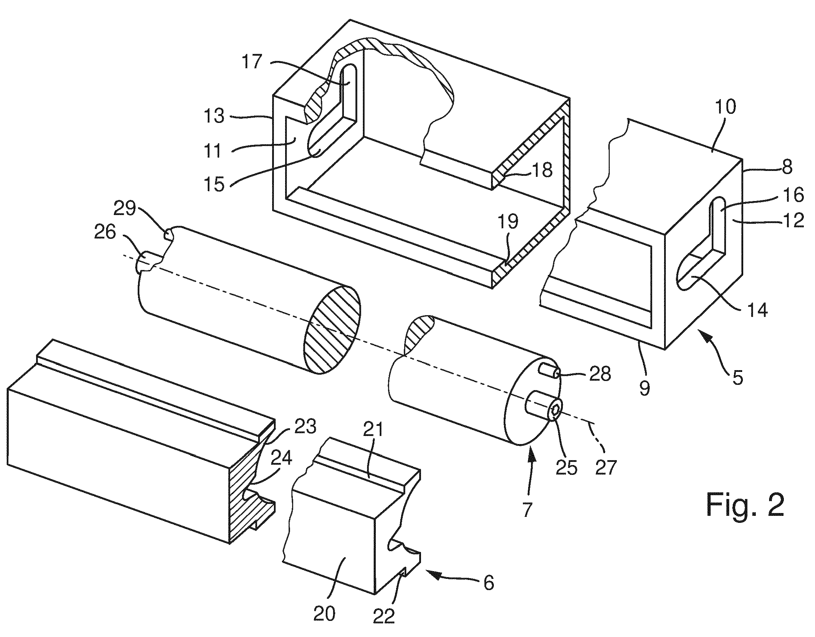

Gemäß Figur 2 besteht die Klemmvorrichtung 4 im Wesentlichen aus drei Bauteilen: einem langgestreckten Gehäuse 5, einem Druckstück 6 und einem Drehzylinder 7.

Das Gehäuse 5 hat einen Querschnitt in Form eines horizontalen U, wobei der U-Rücken die Rückwand 8 und die parallelen U-Schenkel die untere Seitenwand 9 bzw. die obere Seitenwand 10 bilden. Die Vorderseite des Gehäuses 5 wird von einer großen rechteckigen Öffnung 11 eingenommen. Rechte Stirnwand 12 und linke Stirnwand 13 vervollständigen das Gehäuse 5.

In die Stirnwände 12, 13 sind jeweils Langlöcher 14 und 15 eingearbeitet, wobei das Langloch 14 als Durchgangsloch und das Langloch 15 als Sackloch ausgebildet ist. Das Langloch 14 geht in einen Führungsschlitz 16 über, dessen Breite etwas geringer ist als die des Langlochs 14. An der gegenüberliegenden linken Stirnwand 13 ist ein entsprechender Führungsschlitz 17 ausgebildet. Im Bereich der Vorderkanten des Gehäuses 5 sind ein oberer Anschlagwinkel 18 und ein unterer Anschlagwinkel 19 vorgesehen, die im Querschnitt als kurze, an die Enden der U-Schenkel angesetzte und nach innen weisende Stege ausgebildet sind.

Das Druckstück 6 hat die Grundform eines langgestreckten Quaders, der in Form und Abmessungen an das Gehäuse 5 angepasst ist. An der Vorderseite des Druckstücks 6 ist eine ebene Klemmfläche 20 ausgebildet, die parallel zur Rückwand 8 des Gehäuses 5 verläuft. An seiner Oberseite und Unterseite hat das Druckstück 6 eine obere Anschlagkante 21 bzw. eine untere Anschlagkante 22, welche mit den Anschlagwinkeln 18, 19 des Gehäuses 5 korrespondieren. An seiner Rückseite hat das Druckstück 6 eine im Querschnitt runde Ausnehmung 23, die dem Drehzylinder 7 angepasst ist. Entlang der Mittellinie der Ausnehmung 23 verläuft ein Längsschlitz 24, der im Querschnitt als Kerbe erscheint.

Der Drehzylinder 7 ist als langgestreckte massive Walze ausgebildet, dessen Länge ungefähr der Länge des Gehäuses 5 und auch der Länge des Druckstücks 6 entspricht. An seinen gegenüberliegenden Stirnwänden trägt der Druckzylinder 7 zentrische Lagerbolzen 25 und 26, welche seine Drehachse 27 definieren. An seinen Stirnseiten sind zudem Führungsstifte 28 und 29 exzentrisch angeordnet.

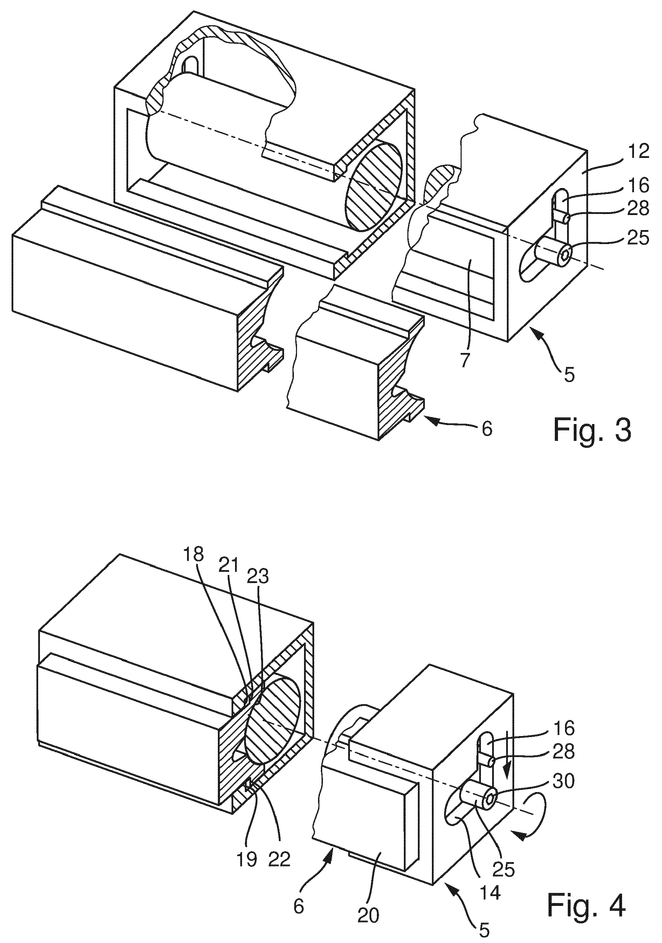

In Figur 3 ist der Drehzylinder 7 in das Gehäuse 5 eingesetzt. Der rechte Lagerbolzen 25 greift in das Langloch 14 in der rechten Stirnwand 12 des Gehäuses 5 ein. Der linke Lagerbolzen 26 (vgl. Fig. 2) greift in das Langloch 15 in der gegenüberliegenden linken Stirnwand 13 des Gehäuses 5 ein. Damit ist der Druckzylinder 7 um seine Drehachse 27 drehbar im Gehäuse 5 gelagert, wobei er sich in den Langlöchern 14, 15 horizontal nach vorne oder hinten verlagern kann. Gleichzeitig greift der rechte Führungsstift 28 in den Führungsschlitz 16 in der rechten Stirnwand 12 des Gehäuses 5 ein, während der linke Führungsstift 29 (vgl. Fig. 2) in den korrespondierenden Führungsschlitz 17 der linken Stirnwand 13 eingreift. Führungsstifte 28, 29 und Führungsschlitze 16, 17 bilden eine Führungskulisse für den Drehzylinder 7, welche bei Drehung um seine Drehachse 27 deren Verlagerung in den Langlöchern 14, 15 steuert.

In Figur 4 ist auch das Druckstück 6 in das Gehäuse 5 eingesetzt. Die Anschlagkanten 21, 22 hintergreifen die Anschlagwinkel 18, 19 des Gehäuses 5. Der Drehzylinder 7 greift in die rückwärtige Ausnehmung 23 des Druckzylinders 7 ein, so dass beide Teile in flächigem Gleitkontakt sind.

Der rechte Lagerbolzen 25 des Drehzylinders 7 ragt durch das Langloch 14 in der rechten Stirnwand 12 des Gehäuses 5 hindurch und ein Stück heraus. An dem somit von außen zugänglichen freien Ende des Lagerbolzens 25 ist eine als Innensechskant 30 ausgeführte Aufnahme für den Einsatz eines handelsüblichen Sechskant-Schlüssels vorgesehen.

Bei Drehung im Uhrzeigersinn, wie in Figur 4 durch den gekrümmten Pfeil angedeutet, fährt der Führungsstift 28 den Führungsschlitz 16 in Richtung des geraden Pfeils ab. Dies bewirkt eine Verlagerung der Drehachse 27 nach vorne. Das Druckstück 6 folgt dieser Verlagerung des Drehzylinders und wird so aus der Vorderseite des Gehäuses 5 ein Stück weit hinausgedrückt.

Figur 5a verdeutlicht die Funktion der Klemmvorrichtung 4, die hier parallel zum Leiterplattenmodul 1 in die Befestigungsnut 3 der Kühlplatte 2 eingesetzt ist. Die vordere Stirnwand des Gehäuses ist in dieser schematischen Zeichnung weggelassen, damit die Bewegungen des Druckstücks 6 und des Drehzylinders 7 im Gehäuse 5 verfolgt werden können.

Zunächst sitzt das Druckstück 6 vollständig innerhalb des Gehäuses 5. Zwischen der Druckfläche 20 und der rechten Nutenwand 31 der Befestigungsnut 3 ist noch ein Spalt. Entsprechend lose liegt die Rückwand 8 des Gehäuses 5 an der Vorderseite des Leiterplattenmoduls 1 an, welches mit seiner Rückseite an der linken Nutenwand 32 der Befestigungsnut 3, ebenfalls noch lose, anliegt. Der Lagerbolzen 26 des Drehzylinders 27 befindet sich nicht weit von seiner hinteren Endstellung im zugehörigen Langloch 15, dessen Lage in der weggelassenen Stirnwand angedeutet ist. Der Führungsstift 29 des Drehzylinders 7 befindet sich in seiner Anfangsstellung am oberen Ende des Führungsschlitzes 17, dessen Lage in der Stirnwand hier ebenfalls angedeutet ist.

Wird nun ein Sechskant-Schlüssel 33 auf das freie Ende des Lagerbolzens 26 aufgesteckt, lässt sich damit der Drehzylinder 7 in Richtung des Pfeils um seine Drehachse 27 drehen. Dabei gleitet der Führungsstift 29 entlang des Führungsschlitzes 17 nach unten, wie in Figur 5b zu sehen. Da sich der Führungsstift 29 gegenüber der Drehachse 27 auf einem Kreis bewegt, der Führungsschlitz 17 aber gerade ist, zwingt die aus Führungsschlitz 17 und Führungsstift 29 gebildete Führungskulisse den Drehzylinder 7 zu einer Verlagerung in horizontaler Richtung nach rechts im Langloch 15. Das Druckstück 6 folgt dieser Verlagerung und verschiebt sich gegenüber dem Gehäuse 5 ebenfalls nach rechts so lange, bis es an der rechten Nutenwand 31 anliegt. Bei weiterem Verdrehen des Sechskant-Schlüssels 33 in Pfeilrichtung baut sich eine Klemmkraft in horizontaler Richtung aus, welche das Leiterplattenmodul 1 zwischen linker Nutenwand 32 und Rückwand 8 des Gehäuses 5 verklemmt.

Langloch 15 und Führungsschlitz 17 bilden einen spitzen Winkel α von ungefähr 75°. Die hierdurch bedingte Gleitreibung des Exzentermechanismus ist so groß, dass ein selbsttätiges Zurückdrehen bzw. eine Rückverlagerung des Druckzylinders 7 ausgeschlossen ist. Der Mechanismus ist durch Selbsthemmung gesperrt. Um die Verklemmung des Leiterplattenmoduls 1 zu lösen, muss der Drehzylinder 7 mittels des Sechskant-Schlüssels 33 von Hand in entgegengesetzter Richtung verdreht werden, wobei die Hemmung überwunden wird.

Die kleinen Pfeile deuten den Wärmetransport an. Die in die Rückwand 8 des Gehäuses 5 eingeleitete Abwärme aus dem Leiterplattenmodul 1 fließt über die Seitenwände 8, 10 in das Druckstück 6 und von dort weiter in die Kühlplatte 2.

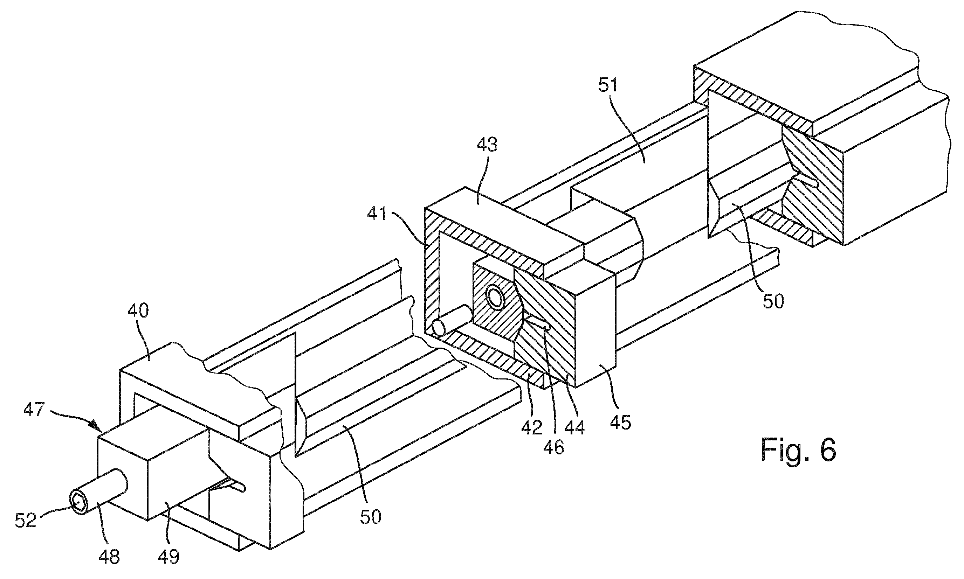

Die erfindungsgemäße Klemmvorrichtung gemäß Figur 6 hat im Prinzip den gleichen Grundaufbau wie die zuvor beschriebene Klemmvorrichtung. Sie unterscheidet sich nur hinsichtlich des Antriebsmechanismus.

Das langgestreckte Gehäuse 40 hat U-förmigen Querschnitt, wobei an eine ebene Rückwand 41 eine untere Seitenwand 42 und eine obere Seitenwand 43 rechtwinklig angesetzt sind. Die Vorderseite des Gehäuses 40 ist offen, ebenso die Stirnseite.

Zwischen den Seitenwänden 42, 43 ist ein Druckstück 44 aus massivem Metall verschieblich gelagert. Das Druckstück 44 hat die Form eines langgestreckten rechteckigen Quaders, dessen Querschnittsform an das Gehäuse 40 angepasst ist. Die Vorderseite des Druckstücks 44 bildet eine ebene Klemmfläche 45, die parallel zur Rückwand 41 des Gehäuses 40 verläuft. An seiner Rückseite hat das Druckstück 44 einen Längsschlitz 46, der in der Art einer Kerbe ausgebildet ist und entlang der Mittellinie verläuft.

Als Antriebsmechanismus zur Verschiebung des Druckstücks 44 gegenüber dem Gehäuse 40 dient hier ein CALMARK Card-Lok Serie 223, der in den Raum zwischen Rückwand 41 und Druckstück 44 eingeschoben ist. Das Card-Lok 47 hat eine Gewindewelle 48, die parallel zur Rückwand 41 des Gehäuses 40 verläuft. Auf der Gewindewelle 48 sind mehrere Keilelemente aufgereiht, darunter zwei Endkeile 49 mit zentrischer Bohrung für die Gewindewelle 48 und dazwischen angeordnete erste Keilstücke 50 und zweite Keilstücke 51, welche zwar ebenfalls von der Gewindewelle 48 durchsetzt werden, jedoch gegenüber dieser sowie auch gegenüber dem jeweils benachbarten Keilelement in seitlicher Richtung beweglich sind.

Die Gewindewelle 48 weist an ihrem vorderen freien Ende einen Innensechskant 42 auf, in den ein handelsüblicher Sechskant-Schlüssel als Drehwerkzeug eingesetzt werden kann. Bei Drehung der Gewindewelle 48 ziehen sich die aufgereihten Keilelemente zusammen infolge des Aufeinandergleitens ihrer Keilflächen. Dabei weichen die ersten Keilstücke 50 quer zur Keilachse in Richtung des Druckstücks 44 aus, während die dazwischen liegenden zweiten Keilstücke 51 in die entgegengesetzte Richtung wandern und sich von innen an die Rückwand 41 des Gehäuses 40 anlegen. Die ersten Keilstücke 50 nehmen das Druckstück 44 mit, dass heißt, dieses wird aus der Vorderseite des Gehäuses 40 hinausgeschoben, bis es an eine Wand der Befestigungsnut anstößt (vgl. Figur 1). Die Gewindewelle 48 lässt sich so weit weiterdrehen, bis sich eine ausreichende Klemmkraft zwischen Nutenwand, Druckstück 44, Keilstücken 50, 51, Rückwand 41 und dem Leiterplattenmodul 1, das befestigt werden soll, aufgebaut hat.

Ein in die Gewindewelle 48 integrierter Drehmomentbegrenzer schützt den Antriebsmechanismus vor Überlastung. Die Reibung zwischen Gewindewelle 48 und Gewinde verhindert ein selbsttätiges Lösen der Verklemmung, so dass keine weitere Verriegelung erforderlich ist. Gelöst wird die Klemmverbindung von Hand einfach dadurch, dass die Gewindewelle 48 in die entgegengesetzte Richtung gedreht wird, wodurch die Keilelemente wieder auseinandergezogen werden und das Druckstück 44 in das Gehäuse 40 einfahren kann.

### Bezugszeichen

- 1: Leiterplattenmodul
- 2: Kühlplatte
- 3: Befestigungsnut
- 4: Klemmvorrichtung
- 5: Gehäuse
- 6: Druckstück
- 7: Drehzylinder
- 8: Rückwand (von 5)
- 9: Untere Seitenwand
- 10: Obere Seitenwand
- 11: Öffnung
- 12: Rechte Stirnwand
- 13: Linke Stirnwand
- 14: Langloch (in 12)
- 15: Langloch (in 13)
- 16: Führungsschlitz (in 12)
- 17: Führungsnut (in 13)
- 18: Oberer Anschlagwinkel
- 19: Unterer Anschlagwinkel
- 20: Klemmfläche (von 6)
- 21: Obere Anschlagkante
- 22: Untere Anschlagkante
- 23: Ausnehmung
- 24: Längsschlitz
- 25: Lagerbolzen (von 7)
- 26: Lagerbolzen
- 27: Drehachse
- 28: Führungsstift
- 29: Führungsstift
- 30: Innensechskant
- 31: Rechte Nutenwand
- 32: Linke Nutenwand
- 33: Sechskant-Schlüssel

- 40: Gehäuse
- 41: Rückwand (von 40)
- 42: untere Seitenwand
- 43: obere Seitenwand
- 44: Druckstück
- 45: Klemmfläche (von 44)
- 46: Längsschlitz
- 47: Card-Lok
- 48: Gewindewelle
- 49: Endkeil
- 50: erstes Keilstück
- 51: zweites Keilstück
- 52: Innensechskant

## Patentansprüche

1. Vorrichtung zur Verklemmung eines Leiterplattenmoduls in einer Befestigungsnut einer Kühlplatte, umfassend
ein langgestrecktes Gehäuse (40) aus Metall, das einen Querschnitt in Form eines horizontalen U hat, wobei der U-Rücken die Rückwand (41) und die U-Schenkel die Seitenwände (42,43) bilden und die Vorderseite im wesentlichen offen ist;
ein Druckstück (44) aus Metall, das zwischen den Seitenwänden (42,43) des Gehäuses (40) quer zu dessen Längsachse verschiebbar gelagert ist und an seiner Vorderseite eine ebene Klemmfläche (45) hat, die parallel zur Rückwand (41) des Gehäuses verläuft; einen in den Raum zwischen der Rückwand (41) des Gehäuses (40) und dem Druckstück (44) eingeschobenen Antriebsmechanismus, der das Druckstück (44) durch die offene Vorderseite des Gehäuses (40) zumindest so weit nach vorne verschiebt, dass es die parallelen Seitenwände (42,43) des Gehäuses (5, 40) überragt und sich mit seiner Klemmfläche (45) an eine gegenüberliegende Wand (32) der Befestigungsnut (3) anlegen kann;
wobei das Druckstück (44) im Wesentlichen die Form eines langgestreckten rechteckigen Quaders hat, dessen Querschnittsform an das Gehäuse (40) angepasst ist und das aus massivem Metall besteht, und das Druckstück (44) zwischen den Seitenwänden (42,43) des Gehäuses gleitend gelagert ist, so dass zwischen Gehäuse (40) und Druckstück (44) ein großflächiger Kontakt besteht; der Antriebsmechanismus eine Anzahl von Keilelementen (49, 50, 51) umfasst, die auf einer Gewindewelle (48) aufgereiht sind, deren Achse parallel zur Rückwand (41) des Gehäuses (40) verläuft, wobei die Keilelemente (49, 50, 51) durch Drehung der Gewindewelle (48) zusammengezogen werden und dabei teilweise seitlich ausweichen, wodurch sich mindestens ein Keilelement (50) an die Rückseite des Druckstücks (44) anpresst und dieses nach vorne schiebt und wodurch sich mindestens ein anderes Keilelement (51) an die Rückwand (41) des Gehäuses (40) anpresst, um den Gegendruck aufzubauen.

2. Vorrichtung nach Anspruch 1, **dadurch gekennzeichnet, dass** die Gewindewelle (48) an ihrem freien Ende eine Aufnahme (52) für den formschlüssigen Eingriff eines Drehwerkzeugs, insbesondere eines Sechskant-Schlüssels (33) aufweist.

3. Vorrichtung nach einem der Ansprüche 1 bis 2, **dadurch gekennzeichnet, dass** das Druckstück (6, 44) an seiner Rückseite einen mittig angeordneten Längsschlitz (24, 46) aufweist, der sich über seine gesamte Länge erstreckt.

## Claims

1. Device for clamping a printed circuit board module in a mounting groove of a cold plate, comprising:
an elongated housing (40) made of metal, the cross-section of which having the shape of a horizontal U, wherein the back of the U forms the back wall (41), the U limbs form the lateral walls (42, 43) and the front side is substantially open;
a pressure piece (44) made of metal mounted between the lateral walls (42, 43) of the housing (40) so as to be transversely displaceable relative to a longitudinal axis of the housing and having a flat clamping surface (45) at the front side, said surface extending parallel to the back wall (41) of the housing;
a drive mechanism, which is inserted in the space between the back wall (41) of the housing (40) and the pressure piece (44) and which pushes the pressure piece (44) forward through the open front side of the housing (40) at least so far that the pressure piece protrudes beyond the parallel lateral walls (42, 43) of the housing (40) and the clamping surface (45) thereof can be seated against an opposing wall (32) of the mounting groove (3);
wherein the pressure piece (44) has the shape of an elongated rectangular cuboid the cross-section of which is matched to the cross-section of the housing (40) and is made of solid steel;
the pressure piece (44) is slideably mounted between the lateral walls (42, 43) of the housing thereby producing a large-surface-contact between the housing (40) and the pressure piece (44);
wherein the drive mechanism comprises a number of wedge elements (49, 50, 51) which are arranged in a row on a threaded shaft (48), the axis of the threaded shaft being parallel to the back wall (41) of the housing (40), wherein the wedge elements (49, 50, 51) are pulled together by a rotation of the threaded shaft (48) and give way laterally at least to some degree, whereby at least one wedge element (50) is pressed against the inner side of the pressure piece (40) and pushes the same forward, and at least one other wedge element (51) is pressed against the back wall (41) of the housing (40) to generate counterpressure.

2. Device according to claim 1, **characterized in that** a free end of the threaded shaft (48) comprises a holder (52) for the positive engagement of a rotary tool, in especially a hexagonal wrench.

3. Device according to one of the claims 1 to 2, **characterized in that** a back side of the pressure piece (44) comprises a centrally disposed longitudinal slot (46) which extends over the entire length.

## Revendications

1. Dispositif de blocage d'un module de cartes de circuits imprimés dans une encoche de fixation d'une plaque de refroidissement, comprenant un boîtier allongé (40) en métal, qui a une section transversale en forme de U horizontal, dans lequel le dos du U forme la paroi arrière (41) et les branches du U forment les parois latérales (42, 43) et le côté avant est essentiellement ouvert,
une pièce de pression (44) en métal, qui est montée entre les parois latérales (42, 43) du boîtier (40) de façon coulissante transversalement à l'axe longitudinal de celui-ci et qui a sur son côté avant une face de serrage plane (45), qui est parallèle à la paroi arrière (41) du boîtier,
un mécanisme d'entraînement inséré dans l'espace entre la paroi arrière (41) du boîtier (40) et la pièce de pression (44), qui déplace la pièce de pression (44) à travers le côté avant ouvert du boîtier (40) vers l'avant au moins jusqu'à ce qu'elle dépasse les parois latérales parallèles (42, 43) du boîtier (5, 40) et qu'elle puisse s'appliquer avec sa face de serrage (45) sur une paroi opposée (32) de l'encoche de fixation (3);
dans lequel
la pièce de pression (44) a essentiellement la forme d'un parallélépipède rectangle allongé, dont la forme de la section transversale est adaptée au boîtier (40) et qui se compose de métal massif,
et la pièce de pression (44) est montée de façon glissante entre les parois latérales (42, 43) du boîtier, de telle manière qu'il existe un contact de grande surface entre le boîtier (40) et la pièce de pression (44); le mécanisme d'entraînement comprend plusieurs éléments de coin (49, 50, 51), qui sont alignés sur un arbre fileté (48), dont l'axe est parallèle à la paroi arrière (41) du boîtier (40), dans lequel les éléments de coin (49, 50, 51) peuvent être serrés par rotation de l'arbre fileté (48) et en l'occurrence s'écarter en partie latéralement, au moins un élément de coin (50) étant ainsi pressé sur le côté arrière de la pièce de pression (44) et déplaçant celle-ci vers l'avant et au moins un autre élément de coin (51) étant ainsi pressé sur la paroi arrière (41) du boîtier (40) afin de créer la contrepression.

2. Dispositif selon la revendication 1, **caractérisé en ce que** l'arbre fileté (48) présente à son extrémité libre un logement (52) pour l'engagement par emboîtement d'un outil de rotation, en particulier d'une clé à six pans (33).

3. Dispositif selon une des revendications 1 à 2, **caractérisé en ce que** la pièce de pression (6, 44) présente sur son côté arrière une fente allongée (24, 46) disposée au milieu, qui s'étend sur toute sa longueur.
